# NEUE EUROPÄISCHE PATENTSCHRIFT

(11) **EP 0 171 716 B2**
(45) Veröffentlichungstag und Bekanntmachung des Hinweises auf die Entscheidung über den Einspruch: **26.04.1995**
(45) Hinweis auf die Patenterteilung: 08.01.1992
(21) Anmeldenummer: 85109704.8
(22) Anmeldetag: 02.08.1985
(51) Int. Cl.: C04B 38/06

(54) **Verfahren zur Herstellung eines porösen piezoelektrischen Materials und nach diesem Verfahren hergestelltes Material**
Process for making a porous piezoelectric material and material made according to the process
Procédé pour la fabrication d'une matière poreuse piézoélectrique et matière produite selon le procédé

(30) Priorität: 16.08.1984 DE 3430186
(43) Veröffentlichungstag der Anmeldung: 19.02.1986
(73) Patentinhaber: SIEMENS AKTIENGESELLSCHAFT, 80333 München (DE)
(72) Erfinder: Kaarmann, Hans, Dr., D-8520 Buckenhof (DE); Lubitz, Karl, Dr., D-8012 Ottobrunn (DE); Mohaupt, Jutta, D-8000 München 2 (DE); Vogt, Martina, D-8510 Fürth (DE); Wersing, Wolfram, D-8011 Kirchheim (DE)

(56) Entgegenhaltungen:
- EP-A- 0 173 864
- GB-A- 2 068 355
- Mat.Res.Bul., Vol. 14, no.12, pp. 1553-1559, 1979
- Ferroelectrics, 1986, Vol. 68, pp. 77-97

## Beschreibung

Die Erfindung betrifft ein Verfahren zur Herstellung eines porösen keramischen Materials mit piezoelektrischen Eigenschaften, bei dem einem Keramikpuller mit piezoelektrischen Eigenschaften, dessen Zusammensetzung dem keramischen Endmaterial entspricht, ein Perlpolymerisat zugefügt und mit diesem vermengt wird, das später in einem ersten Brennvorgang ausgebrannt und die die Größe und Menge der Poren bestimmt.

Derartige poröse Piezokeramiken kommen insbesondere in der medizinischen Ultraschalltechnik zum Einsatz.

Für Ultraschallantennen oder Ultraschallwandler, z.B. für ein lineares oder ein Phased Array, in der medizinischen Technik benötigt man ein piezoelektrisches Material, mit welchem folgende vier Bedingungen a) bis d) möglichst gut erfüllt sind:
a) Eine hohe Wandlereffektivität, d.h. ein piezoelektrisches Material mit möglichst hohem Dikkenkopplungsfaktor Kₜ,
b) ein präzises Absenden kurzer Impulse ohne Randabstrahlung um Artefakte durch Quermoden zu verhindern, d.h. ein piezoelektrisches Material mit möglichst geringer Querkopplung Kₚ oder K₃₁ und hoher innerer Dämpfung (gleichbedeutend mit einer niedrigen Schwinggüte Q),
c) eine gute elektrische Anpassung zwischen der Ultraschallantenne und der Signalleitung, d.h. die Permittivität des piezoelektrischen Materials soll in Abhängigkeit von der Wandlergröße und Frequenz gut einstellbar oder leicht wählbar sein, und
d) eine gute akustische Anpassung an das zu untersuchende Objekt, d.h. im Fall der medizinischen Technik eine gute Anpassung an das (menschliche) Gewebe, d.h. der Wert der akustischen Impedanz des piezoelektrischen Materials soll möglichst nahe dem Wert der Impedanz des zu untersuchenden Objekts sein.

Mit den herkömmlichen piezoelektrischen Materialien (Piezomaterialien) lassen sich alle vier genannten Anforderungen a) bis d) nur bedingt erfüllen. Außerdem müßte man wohl ein aufwendiges Verfahren zur Herstellung der Ultraschallantennen in Kauf nehmen. So wird in der Regel das piezoelektrische Material so gewählt, daß die Bedingungen a) und c) gut erfüllt werden. Befriedigende Ergebnisse bezüglich der Anforderung b) werden dadurch erreicht, daß die einzelnen Wandlerelemente der Ultraschallantenne feingeteilt werden, und daß ein Dämpfungskörper an der Rückseite der Ultraschallantenne angebracht wird. Um der Bedingung d) zu genügen, ist man dazu übergegangen, eine Anpassungsschicht der Dicke λ/4 zwischen der Ultraschallantenne und dem menschlichen Gewebe vorzusehen. Wesentlich bessere Ergebnisse lassen sich durch zwei Anpassungsschichten der Dicke λ/4 erzielen. λ ist hierbei die Wellenlänge des Ultraschalls.

Durch Verwendung spezieller Piezokeramiken wie PbNb₂O₆ oderLow-Q-Keramiken (z.B. Vibrit 668) kann man die Anforderung b) recht gut erfüllen, muß aber bei den Anforderungen a) und c) Abstriche vornehmen. Anpassungsschichten sind auch in diesem Fall erforderlich.

Durch Verwendung eines piezoelektrischen Kunststoffes (PVF₂) sind die Anforderungen b) und d) sehr gut, die Anforderungen a) und c) hingegen aber nur mäßig erfüllt.

Das in der GB-A-2 068 355 beschriebene Verfahren hat ebenfalls zum Ziel, poröse Keramik und insbesondere Piezokeramik herzustellen. Dort werden die Ausgangsmaterialien zur Keramikherstellung mit Binder granuliert, gemischt und gepreßt, wobei dann bei der Sinterung eine Reaktion zur Keramik stattfindet. Der Umsatz zur Keramik ist mit einer Volumenvergrößerung und Porositätsbildung - anomale Expansion - verbunden. Dieses Verfahren hat bei der Herstellung von Piezokeramik den Nachteil, daß die poröse, gesinterte Piezokeramik stark inhomogen ist.

Die GB-A-2 068 355 erwähnt ein weiteres Herstellverfahren für poröse Keramik. Dem Keramikpulver wird ein Binder oder eine organische Substanz zugeführt um eine größere Porenmenge zu erhalten. Jedoch weist eine derart hergestellte Keramikstruktur eine schlechte "connectivity" auf, d.h. die gesinterten Keramikteilchen sind schlecht zusammengefügt, der poröse Keramikwerkstoff kann bei der Bearbeitung oder bei Beanspruchung leicht wieder zerfallen.

Ein Verfahren der eingangs genannten Art ist in dem Artikel von Shrout/Schulze/Biggers mit dem Titel "Simplified Fabrication of PZT/Polymer Composites", erschienen in Mat. Res. Bull. Vol. 14(1979), pp. 1553 - 1559, beschrieben. Das Herstellungsverfahren für elektroakustische Wandler geht aus von einer Mischung von PZT-Pulver mit Polymethyl-Methacrylat-Kügelchen (PMM Kügelchen) mit Durchmessern im Bereich von 50 »m bis 150 »m. Die PMM Kügelchen werden vor dem eigentlichen Sinterprozeß verdampft und erzeugen so eine poröse Keramik. Nach dem Sintern und Vergießen wird die poröse Keramik polarisiert. Jedoch ist der Dickenkopplungsfaktor und damit die Wandlereffektivität des so hergestellten porösen Wandlers auf zum Teil unter die Hälfte des Dickenkopplungsfaktors eines homogenen Wandlers abgesunken.

Aufgabe der Erfindung ist es daher, ein Herstellungsverfahren anzugeben, mit welchem ein poröses, piezoelektrisches keramisches Material hergestellt werden kann, das die obigen Anforderungen a) bis d) gleichermaßen gut erfüllt, wobei die poröse Keramik eine ausreichende "connectivity" aufweisen soll, so daß das Material gut weiterverarbeitbar und beanspruchbar ist. Außerdem sollen die Herstellungskosten verhältnismäßig gering sein. Das Material soll insbesondere zum Einsatz in der medizinischen Ultraschalltechnik, aber auch in anderen Ultraschalltechniken wie z.B. der Werkstoff-Untersuchung einsetzbar sein.

Diese Aufgabe wird erfindungsgemäß dadurch gelöst, daß das Perlpolymerisat eine zentrale Perlgröße zwischen 10 »m und 40 »m aufweist

Durch das Zumengen von Perlpolymerisat zu dem keramischen piezoelektrischen Ausgangsmaterial werden in dem Gemisch Räume geschaffen, in welches kein piezoelektrisches Material vorhanden sein kann. In dem genannten ersten Brennvorgang wird, das Perlpolymerisat ausgebrannt, und das keramische piezoelektrische Material wird soweit verfestigt, daß es die Hohlräume, die durch das Perlpolymerisat entstanden sind, nicht einnehmen kann. Auf diese Weise entsteht bei Wahl eines geeigneten keramischen Ausgangsmaterials und eines geeigneten Perlpolymerisat ein poröses piezoelektrisches Material, welches die genannten vier Anforderungen a) bis d) gleichermaßen gut erfüllt.

Eine besonders vorteilhafte Ausgestaltung der Erfindung besteht darin, daß das piezoelektrische Ausgangsmaterial in vorgranulierter Form dem Perlpolymerisat zugemischt wird. Dadurch wird erreicht, daß das Gemisch schon untereinander verklebt ist, bevor eine spätere Formgestaltung des Gemisches vorgenommen wird. Dadurch wird die Formgestaltung einfacher als bei Verwendung von nicht vorgranuliertem piezoelektrischen Ausgangsmaterial.

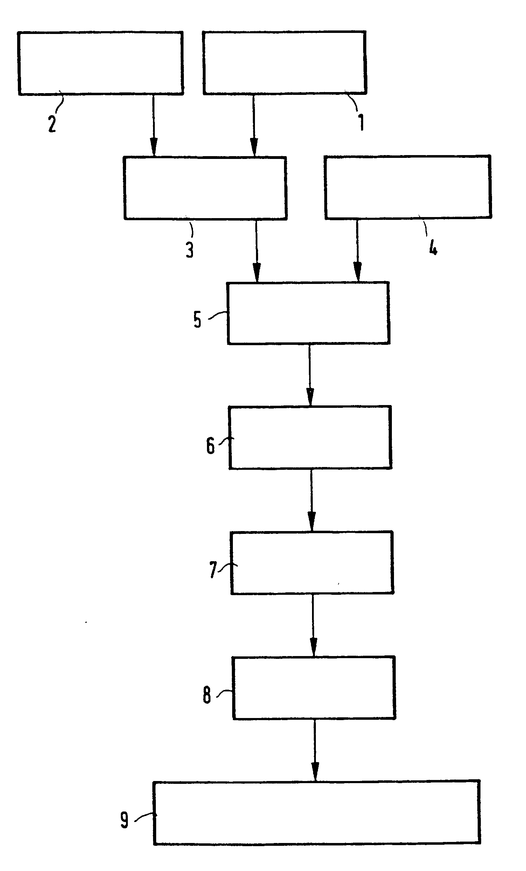

Weitere Vorteile und Ausgestaltungen der Erfindung ergeben sich aus der Figur in Verbindung mit den Unteransprüchen sowie aus der folgenden Beschreibung von bevorzugten Eigenschaften.

Die Figur zeigt ein Flußdiagramm zur Herstellung einer porösen piezoelektrischen Keramik mit piezoelektrischen Eigenschaften.

Ausgegangen wird von einem herkömmlichen Keramikpulver 1 mit piezoelektrischen Eigenschaften (Ausgangsmaterial). Zum besseren Zusammenhalt der Pulverpartikel untereinander wird das Keramikpulver 1 mit einem Bindemittel 2 gemischt und dabei zu einem Granulat 3 weiterverarbeitet. Das Keramikpulver 1 ist so beschaffen, daß es bei normaler Weiterverarbeitung zu einer gewöhnlichen Keramik mit einem Dickenkopplungsfaktor Kₜ = 0,5, mit einer gewünschten Querkopplung Qₚ, mit einer Schwinggüte Q = 200 und (je nach gewünschter Permittivität) mit einer Dielektrizitätskonstanten ε zwischen 500 und 5000 führen würde.

Das Granulat 3 wird nun mit einem Perlpolymerisat 4 zu einer Mischung 5 vermengt, insbesondere zu einem preßfähigen Mischgranulat verarbeitet. Unter dem Begriff "Perlpolymerisat" wird hier ein Polymerisat in Form von kleinen Teilchen verstanden, die bevorzugt eine runde Form aufweisen sollen mit einer zentralen Perlgröße zwischen 10 und 40 »m. Als besonders vorteilhaft hat sich ein Wert von 20 »m herausgestellt. Als Perlpolymerisat 4 eignet sich insbesondere Polymethylmethacrylat. Prinzipiell kann natürlich auch eine andere ausbrennbare Substanz gewählt werden. Der Masseanteil des Perlpolymerisats 4 an der Mischung 5 beträgt je nach den gewünschten Eigenschaften des Endprodukts zwischen 10 und 40 %. Die Mischung 5 soll möglichst homogen sein, d.h. eine gleichmäßige Verteilung von Keramikpulver 1 und Perlpolymerisat 4 aufweisen.

Nach einer Variante des Verfahrens ist es möglich, das Bindemittel 2 erst später zusammen mit dem Keramikpulver 1 und dem Perlpolymerisat 4 zu der Mischung 5 zu verarbeiten. Es ergibt sich dann ein Mischgranulat, in welchem auch das Perlpolymerisat 4 klebend eingebunden ist. Ebenfalls ist es denkbar, auf die Zugabe des Bindemittels 2 gänzlich zu verzichten.

Eine weitere Variante sieht vor, das Keramikpulver 1 zu einem ersten Schlicker und das Perlpolymerisat 4 zu einem zweiten Schlicker zu verarbeiten und die beiden Schlicker anschließend zu vermengen. Unter Schlicker wird dabei die Substanz verstanden, bei der Teilchen in einer Flüssigkeit aufgeschlemmt sind. Das kann dabei unter Zugabe von Dispersionsmitteln geschehen sein.

Je nach Vorbehandlung des Keramikpulvers 1 und des Perlpolymerisats 4 werden zur Herstellung der Mischung 5 unterschiedliche Methoden A) bis C) verwendet:
A) Im Ausführungsbeispiel gemäß der Figur wird dem vorgranulierten Keramikpulver 3 das Perlpolymerisat 4 in der gewünschten Menge in einer Mischeinrichtung, z.B. in einer Kugelmühle, zugemischt.
B) Bei größeren Mengen werden das Keramikpulver 1, das Bindemittel 2 und das Perlpolymerisat 4 gemeinsam gemischt und anschließend in einer geeigneten Granulier maschine, wie z.B. in einem Wirbelgranuliergerät granuliert. Es ist darauf zu achten, daß sich das Perlpolymerisat 4 nur sehr wenig oder gar nicht im verwendeten Bindemittel 2 löst. Vorteilhaft ist hier, wenn die Kunststoffkörner des Perlpolymerisats 4 Nukleationszentren zur Bildung von Primärteilchen darstellen, die sich durch einen Oberflächenanlagerungsmechanismus vergrößern.
C) Wird das Keramikpulver 1 und das Perlpolymerisat 4 vor dem Mischen zu dem ersten bzw. dem zweiten Schlicker verarbeitet, so bietet sich zur Herstellung der Mischung 5 ein Sprühturm an. Dort werden beide Schlicker im gewünschten Mengenverhältnis versprüht. Dabei werden beide Schlickerströme erst kurz vor der Sprühdüse zusammengeführt, wodurch eine Entmischung vermieden wird.

An die Herstellung der Mischung 5 schließt sich als nächster Verfahrensschritt eine formgebende Behandlung der Mischung 5 an. Es kann dies z.B. ein Pressen 6 der Mischung 5 zu einem quaderförmigen Block sein. Je nach Verwendungszweck des Endprodukts können stattdessen auch Scheiben oder Zylinder gepreßt werden, oder es können Rohre in einem Strangpreßverfahren hergestellt werden.

Nach der Formgestaltung 6 zu dem quaderförmigen Block schließt sich ein erster Brennvorgang 7 an. In diesem ersten Brennvorgang 7 wird der relativ hohe Anteil an organischer Substanz, also der Anteil an Perlpolymerisat 4 und Bindemittel 2, aus dem quaderförmigen Block ausgebrannt. Der Temperaturverlauf und die Sauerstoffzufuhr werden nach einem vorgegebenen Programm geregelt, z. B. 1 ° C/min bis 550 ° C sowie 1,6 l Sauerstoff pro Gramm Perlpolymerisat plus Binderfeststoffanteil. Nach dem ersten Brennvorgang 7 erhält man den Block mit einer definierten Porosität von etwa 10 bis 50 % entsprechend der Menge des zugesetzten Perlpolymerisats 4.

Dem ersten Brennvorgang 7 folgt ein zweiter Brennvorgang 8, der sich vorteilhafterweise direkt an den ersten Brennvorgang 7 anschließt, ohne daß eine Abkühlungsphase zwischen den beiden Brennvorgängen 7, 8 erfolgt. Dieser eigentliche Brennvorgang wird unter Bedingungen durchgeführt, die für das gewählte Keramikmaterial optimal sind. Der zweite Brennvorgang 8 dient dazu, den porösen Block zu sintern, so daß seine mechanische Festigkeit erhöht wird. Der so bearbeitete, poröse und gesinterte Block kann nunmehr mit einer oder mehreren gängigen Bearbeitungsmethoden 9, wie z.B. Sägen, Schleifen etc., zum gewünschten Endprodukt, in diesem Fall zu Ultraschallantennen, weiterverarbeitet werden.

Die bisher beschriebene Ausgestaltung des Herstellungsverfahrens dient bevorzugt der Herstellung von Preßteilen.

Eine andere Ausgestaltung des Verfahrens sieht vor, piezoelektrische Keramikfolien definierter Porosität durch an sich bekannte Gieß- oder Ziehverfahren herzustellen, und zwar insbesondere für Ultraschallwandler, die bei höheren Frequenzen wie etwa 5 MHz arbeiten. Dazu wird der erste Schlicker, der mit dem piezoelektrischen Pulver aufbereitet wurde, zu einer dünnen Folie geformt. Diesem sogenannten "Folienschlicker" wird das Perlpolymerisat 4 beigemischt. Dieses kann wiederum bevorzugt eine zentrale Perlgröße von ca. 20 »m besitzen. Dabei ist darauf zu achten, daß sich das Perlpolymerisat 4 nicht im Lösungsmittel, das zur Schlickerverdünnung verwendet wird, löst.

Bei dieser Ausgestaltung des Verfahrens kann eine Entmischung zwischen dem Perlpolymerisat 4 und dem Keramikpulver 1 während des Trocknungsprozesses auftreten, bei dem das Lösungsmittel verdunstet. Eine solche Entmischung führt zu einem Dichtegradienten in der gebrannten Keramikfolie, d.h. die Porosität ist auf einer Seite der Folie höher, als auf der anderen Seite. Dieser Effekt ist kein Nachteil. Er läßt sich vielmehr bei der Herstellung von Ultraschallwandlern gezielt einsetzen. Es wird dadurch erreicht, daß - wenn die poröse Keramikfolie als Anpassungsschicht mit einer Dicke λ /4 verwendet wird - mit dieser Anpassungsschicht eine wesentlich breitbandigere Anpassung möglich ist als bei einer homogenen Porenverteilung. Bei dieser Anwendung ist die Seite mit hoher Porosität der anzupassenden Schicht zugewandt, also z.B. dem menschlichen Gewebe, und die Seite niederer Porosität ist der Ultraschallantenne zugewandt.

Zum Erreichen der gewünschten Endform eines Ultraschallwandlers werden die piezoelektrischen porösen Keramikteilchen oder Keramikkörper mit Elektroden oder Elektrodenstrukturen versehen. Dies erfolgt mit bekannten Aufdampf- oder Sputterverfahren.

Nach Anbringen der Elektroden werden die porösen Keramikteilchen oder -körper polarisiert. Allerdings ist das Polarisieren von Keramiken mit hoher Porosität nicht einfach. Aufgrund der dazu benötigten relativ hohen elektrischen Feldstärke können Entladungsvorgänge in den Poren der Keramik auftreten. Diese Entladungsvorgänge führen zu inneren Kurzschlüssen und damit zu einer Reduzierung des Piezoeffektes. Es ist daher vorteilhaft, die porösen Keramikteilchen unter Druck in einem Schutzgas, insbesondere Schwefelhexafluorid (SF₆), das in die Poren eindringen kann, zu polarisieren.

Weiterhin kann es zweckmäßig sein, für die weitere Verarbeitung der Keramikteile deren Poren mit einer bekannten Vakuumvergußmethode mit Kunststoff zu füllen.

Bei den erläuterten Ausführungsbeispielen werden die eingangs genannten Forderungen a) bis d) besonders gut erfüllt.
- Zu a):: Der Dickenkopplungsfaktor Kₜ ist ungefähr gleich 0,5 und damit ausreichend hoch. Dies ist selbst für normale Keramik ein guter Wert.
- Zu b):: Die Querkopplung K₃₁ und die Schwinggüte Q der porösen Keramik sind gegenüber gewöhnlichen Keramiken sehr niedrig. Die Querkopplung K₃₁ beträgt ca. 0,1 und die Schwinggüte Q ungefähr 20.
- Zu c):: Durch Verwendung verschiedener piezoelektrischer Keramikpulver als Ausgangsmaterial kann die poröse Keramik (Endprodukt) mit einer Permittivitätszahl von etwa 200 bis 1200 hergestellt werden. Damit kann insbesondere bei Ultraschallantennen (Wandern) in der Medizintechnik für nahezu alle Anwendungsfälle eine gute elektrische Anpassung erreicht werden.
- Zu d):: Die akustische Impedanz beträgt bei normalen piezoelektrischen Keramiken über 30 x 10⁶ kg/m²s. Sie kann demgegenüber bei der hier betrachteten porösen Keramik so niedrig gewählt werden, z.B. mit einem Wert 10 x 10⁶ kg/m²s, daß man mit nur einer einzigen Anpassungsschicht der Dikke λ/4 eine genauso gute akustische Anpassung erreicht, wie es andernfalls beim Einsatz nicht poröser Keramiken erst mit zwei Anpassungsschichten der Dicke λ/4 möglich wäre. Als Vorteil ist in diesem Zusammenhang festzuhalten, daß die akustische Impedanz der Keramik bei ansonsten praktisch konstanten Parametern verschieden gewählt werden kann, und zwar über die Menge des beigemischten Perlpolymerisats.

## Patentansprüche

1. Verfuhren zur Herstellung eines porösen keramischen Materials mit piezoelektrischen Eigenschaften, bei dem einem Keramikpulver (1) mit piezoelektrischen Eigenschaften, dessen Zusammensetzung dem keramischen Endmaterial entspricht, ein Perlpolymerisat zugefügt und mit diesem vermengt wird, das später in einem ersten Brennvorgang (7) ausgebrannt wird und das die Größe und Menge der Poren des keramischen Endmaterial bestimmt, **dadurch gekennzeichnet,** daß das Perlpolymerisat (4) eine zentrale Perlgröße zwischen 10 »m und 40 »m aufweist.

2. Verfahren nach Anspruch 1, **dadurch gekennzeichnet,** daß das piezoelektrische Ausgangsmaterial (1) in Pulverform mit dem Perlpolymerisat (4) zu einer Mischung (5) vermengt wird.

3. Verfahren nach Anspruch 2, **dadurch gekennzeichnet,** daß die Mischung (5) vor dem ersten Brennvorgang (7) in eine vorgegebene Form gebracht wird.

4. Verfahren nach einem der Ansprüch 1 bis 3, **dadurch gekennzeichnet,** daß das piezoelektrische Ausgangsmaterial zu einem ersten Schlicker verarbeitet wird, bevor es mit dem Perlpolymerisat vermengt wird.

5. Verfahren nach Anspruch 4, **dadurch gekennzeichnet,** daß das Perlpolymerisat zu einem zweiten Schlicker verarbeitet wird, bevor es mit dem ersten Schlicker vermengt wird.

6. Verfahren nach einem der Ansprüche 1 bis 5, **dadurch gekennzeichnet,** daß das Perlpolymerisat beim Vermengen einen Massenanteil von 10 bis 50 % besitzt.

7. Verfahren nach einem der Ansprüche 1 bis 6, **dadurch gekennzeichnet,** daß dem ersten Brennvorgang ein zweiter Brennvorgang folgt, wobei die Brenntemperatur des zweiten Brennvorgangs höher ist als diejenige des ersten Brennvorgangs.

8. Verfahren nach Anspruch 7 zur Herstellung eines piezoelektrischen Materials zum Einsatz in der Ultraschalltechnik**, dadurch gekennzeichnet,** daß das Material nach dem zweiten Brennvorgang in einem elektrischen Feld polarisiert wird.

9. Verfahren nach Anspruch 9, **dadurch gekennzeichnet,** daß beim Polarisieren ein elektrisch nicht leitendes Schutzgas in die durch das Ausbrennen des Perlpolymerisats entstandenen Hohlräume eingebracht wird.

## Claims

1. Method for the production of a porous ceramic material having piezoelectric properties, in which method there is added to a ceramic powder (1) having piezoelectric properties, the composition of which ceramic powder (1) corresponds to the ceramic end product, a pearl polymer which is mixed with said ceramic powder (1) and is later fired out in a first firing step (7), and which determines the size and number of the pores of the ceramic end product, characterized in that the pearl polymer (4) has a central pearl size between 10 »m and 40 »m.

2. Method according to claim 1, characterized in that the piezoelectric starting material (1) is mixed in powder form with the pearl polymer (4) to produce a mixture (5).

3. Method according to claim 2, characterized in that the mixture (5) is formed into a predetermined shape before the first firing step (7).

4. Method according to one of claims 1 to 3, characterized in that the piezoelectric starting material is processed to produce a first slip before it is mixed with the pearl polymer.

5. Method according to claim 4, characterized in that the pearl polymer is processed to produce a second slip before it is mixed with the first slip.

6. Method according to one of claims 1 to 5, characterized in that, during mixing, the pearl polymer has a mass proportion of 10 to 50%.

7. Method according to one of claims 1 to 6, characterized in that a second firing step follows the first firing step, the firing temperature of the second firing step being higher than that of the first firing step.

8. Method according to claim 7 for the production of a piezoelectric material for use in ultrasonics, characterized in that the material is polarised in an electrical field after the second firing step.

9. Method according to claim 9, characterized in that, during polarisation, an electrically non-conductive inert gas is introduced into the cavities formed by the firing-out of the pearl polymer.

## Revendications

1. Procédé de fabrication d'un matériau céramique poreux ayant des propriétés piézoélectriques qui consiste à ajouter et à mélanger à une poudre céramique (1), ayant des propriétés piézoélectriques et de composition correspondant à la matière céramique finale, un polymère sous forme de perles qu'ultérieurement on fait se consumer dans un premier stade de combustion (7) et qui détermine la dimension et la quantité des pores du matériau céramique final, caractérisé en ce que le polymère (4) sous forme de perles a une dimension centrale des perles comprise entre 10 »m et 40 »m.

2. Procédé suivant la revendication 1, caractérisé par le fait qu'on mélange le matériau piézoélectrique de départ (1) à l'état pulvérulent, au polymère sous forme de perles (4) pour former un mélange (5).

3. Procédé suivant la revendication 2, caractérisé par le fait qu'on donne au mélange (5) une forme prédéterminée avant le premier stade de combustion.

4. Procédé suivant l'une des revendications 1 à 3, caractérisé par le fait qu'on traite le matériau piézoélectrique de départ pour former une première suspension, avant de le mélanger au polymère sous forme de perles.

5. Procédé suivant la revendication 4, caractérisé par le fait qu'on traite le polymère sous forme de perles pour former une seconde suspension avant de le mélanger à la première suspension.

6. Procédé suivant l'une des revendications 1 à 5, caractérisé par le fait que le polymère sous forme de perles intervient, lors du mélange, pour un pourcentage de 10 à 50% en masse.

7. Procédé suivant l'une des revendications 1 à 6, caractérisé par le fait que le premier stade de combustion est suivi d'un second stade de combustion, lors duquel la température de combustion est supérieure à celle utilisée lors du premier stade de combustion.

8. Procédé suivant la revendication 7 pour fabriquer un matériau piézoélectrique destiné à être utilisé dans la technique des ultrasons, caractérisé par le fait qu'on polarise le matériau dans un champ électrique, après le second stade de combustion.

9. Procédé suivant la revendication 8, caractérisé par le fait que lors de la polarisation, on introduit un gaz protecteur non électriquement conducteur dans les cavités qui se forment sous l'effet de la combustion du polymère sous forme de perles.
